# EUROPEAN PATENT SPECIFICATION

(11) **EP 1 538 672 B1**
(45) Date of publication and mention of the grant of the patent: **05.12.2007**
(21) Application number: 03733173.3
(22) Date of filing: 29.05.2003
(51) Int. Cl.: H01L 27/04, H01L 21/02, H01L 23/522

(54) **SEMICONDUCTOR DEVICE**
HALBLEITERBAUELEMENT
DISPOSITIF SEMI-CONDUCTEUR

(43) Date of publication of application: 08.06.2005
(73) Proprietor: MITSUBISHI DENKI KABUSHIKI KAISHA, Chiyoda-ku Tokyo 100-8310 (JP)
(72) Inventor: NISHIKAWA, Kazuyasu c/o MITSUBISHI DENKI, Chiyoda-ku, Tokyo 100-8310 (JP); HASHIZUME, Yasushi c/o MITSUBISHI DENKI, Chiyoda-ku, Tokyo 100-8310 (JP)
(74) Representative: Hofer, Dorothea
(86) International application number: PCT/JP2003/006780
(87) International publication number: WO 2004/107444

(56) References cited:
- WO-A-02/49110
- JP-A- 6 181 289
- JP-A- 7 074 311
- JP-A- 11 054 705
- JP-A- 2003 068 862
- US-A1- 2002 155 655
- US-A1- 2003 071 263
- PATENT ABSTRACTS OF JAPAN vol. 2003, no. 07, 3 July 2003 (2003-07-03) -& JP 2003 068862 A (SHARP CORP), 7 March 2003 (2003-03-07)
- PATENT ABSTRACTS OF JAPAN vol. 1995, no. 06, 31 July 1995 (1995-07-31) -& JP 07 074311 A (TOSHIBA CORP), 17 March 1995 (1995-03-17)
- PATENT ABSTRACTS OF JAPAN vol. 2000, no. 08, 6 October 2000 (2000-10-06) -& JP 2000 150802 A (NEC CORP), 30 May 2000 (2000-05-30)

## Description

### TECHNICAL FIELD

The present invention relates to a semiconductor device, and more particularly relates to a semiconductor device provided with a high frequency circuit having an inductor.

### BACKGROUND ART

US 2002/0155655 A1 discloses plugs that are encircling a circuit element that may generate noise or may be affected by noise or electromagnetic interference. The encircling plug may be closed by an interconnection layer. Further, the plug may be grounded to reduce the electromagnetic interference or noise generated by or coupled to said passive circuit element.

WO 02/49110 A1 describes a shielded inductor, wherein trenches, which are filled with an electrically isolating material, are located under the inductor path and are arranged in a mesh-like or grid pattern. The whole inductor structure is surrounded by a frame constituted of regions of the same metal layer as metal areas in a plane under the inductor. The metal frame is a continuous strip having a gap to make an open structure in order to avoid circulating currents.

A semiconductor device provided with high frequency circuits includes an inductor in addition to a resistor and a capacitor. The combination of the inductor and capacitor in action enables matching of the high frequency circuits. When a high frequency current now flows through the inductor, an electromagnetic wave is radiated from the inductor. Accordingly, when other elements (a transmission line, capacitor, resistor, and another inductor) exist around the inductor, an electromagnetic coupling (electromagnetic interference) is caused between the element and the inductor. For example, if the inductor and another inductor electromagnetically interfere with each other, a mutual inductance is caused therebetween, thereby changing the desired magnitude of inductance. In this case, the inductor cannot offer its intrinsic performance. It is known that such a phenomenon remarkably occurs when the substrate is a conductive substrate.

In order to prevent such an inconvenience, a distance is commonly put between the inductor and other elements such that the electromagnetic coupling reduces. However, this method can only reduce the electromagnetic interference, but the length of a line connecting the elements becomes long. Therefore, there arises another inconvenience that the line loss is increased. Moreover, because of difficulty in size reduction of the circuit, a high degree of integration cannot be achieved.

Then, in addition to the above-described method, there is proposed a technology intended for the prevention of the electromagnetic interference by disposing a guard ring over a wide area around the inductor. To be more specific, the guard ring is formed in the activation area (for example, the silicon substrate itself, or the electron- injected or positive-hole-inj ected layer of the substrate when the substrate is an injected silicon substrate) of the semiconductor, thereby isolating the activation area. In such a way, the electromagnetic interference caused between the other elements existing around the inductor and the inductor via the silicon substrate can be suppressed, thereby reducing the noise produced by the electromagnetic interference.

However, because the guard ring is arranged to enclose or surround the inductor, the size thereof becomes 1.5 or more times as large as the diameter of the spiral pattern of the inductor. For this reason, in the semiconductor device, the occupied area of the guard ring becomes large. Further, in the area of the guard ring, other elements cannot be disposed. Accordingly, there arises an inconvenience that size reduction of the circuit in the device and a high degree of integration in the circuit cannot be achieved.

Moreover, the above-mentioned composition is effective at preventing the electromagnetic interference caused through the silicon substrate; however, it is difficult to prevent the electromagnetic interference caused in a horizontal direction to the substrate. In addition, because the guard ring is often connected to the silicon substrate or the ground, other elements located around the inductor occasionally receive an electromagnetic influence through the guard ring. For example, the elements located around the inductor are placed close also with respect to the guard ring formed to enclose the inductor. Herein, if a ground exists in the vicinity of the propagation path of a high frequency signal, the signal flowing through the inductor and the elements propagates based on the potential of the ground. Consequently, stray capacitance increases between the inductor and the guard ring and also between the elements around the inductor and the guard ring.

Moreover, because the guard ring larger than the inductor is formed, it is necessary to increase the length of the lead line and the lead-out line, and therefore the distance through which the high frequency signal propagates accordingly increases. For this reason, there can develop the inconvenience that the circuits become easily influenced by the ground via the guard ring, and the characteristic impedance thereof is changed.

Further, if the guard ring is formed by using the activation area of the semiconductor as mentioned above, the resistance thereof becomes larger than that of interconnection material such as aluminum or copper. Accordingly, even if the guard ring is connected to the ground, the resistance of the ring itself is interposed between the ground and the ring, and the guard ring is at a higher potential as compared with other elements connected to the ground. In this case, the high frequency signal propagates based on a potential that is somewhat higher than that of the ground. This may become a factor to deteriorate the characteristic of the inductor.

As a technology of suppressing the electromagnetic interference without using the above-described guard ring, there is disclosed a method of providing a patterned ground shield layer between the silicon substrate and the inductor (for example, see JP-A-2001-308273). A silicon substrate has a specific resistance that is lower as compared with that of other compound semiconductors. For this reason, there has been an inconvenience that a signal loss becomes large because of the parasitic effect arising from the substrate. In this connection, the provision of the above-mentioned patterned ground shield layer can reduce the electromagnetic induction loss in the silicon substrate, and further, the provision can also prevent an electromagnetic wave radiated to the silicon substrate from flowing in other elements.

However, this composition can only prevent the noise and electromagnetic interference produced through the silicon substrate; however, this composition cannot prevent the electromagnetic interference caused in a horizontal direction to the substrate. Moreover, there is a problem that a Q-value (Quality Factor) is deteriorated by the patterned ground shield, depending on the magnitude of the inductance, and the self-resonant frequency (the frequency at which the Q-value becomes zero) reduces, thereby narrowing the applicable frequency range of the inductor for serving as the inductor.

As another technology of reducing the electromagnetic interference, there is disclosed a method of providing a ground electrode at the sides of the inductor (for example, see JP-A-2002-093622). In this composition, it is possible to define the ground electrodes provided at the sides of the inductor as the return of the high frequency signal; however, it is impossible to define the return on the side of the input terminal and the side of the output terminal of the inductor. For this reason, there is an inconvenience that the radiation of the electromagnetic wave from the inductor cannot be suppressed, and the radiation influences other elements existing around the inductor.

Moreover, there is also disclosed a method of providing a resistive layer between the inductor and the silicon substrate and disposing a discontinuous conductive pattern connected to a ground between the outer periphery of the inductor and the spiral pattern thereof (for example, see JP-A-2002-305110). This composition can reduce the stray capacitance formed between the inductor and the silicon substrate. However, because the discontinuous conductive portion is connected to the ground through the semiconductor layer having high resistance, the potential of the semiconductor layer becomes higher as compared with that of the ground. For this reason, only the stray capacitance of the inductor can be reduced; however, the resistive components of the inductor increase. As a result, there is a problem that the performance (Q-value and self-resonant frequency) of the inductor deteriorates.

### DISCLOSURE OF THE INVENTION

The present invention is defined by the semiconductor device according to claim 1.

According to a first aspect the semiconductor device includes: an inductor provided with a conductor interconnection formed in spiral form on a semiconductor substrate; and a shield that is provided with a continuous conductor interconnection provided along the periphery of the spiral pattern of the inductor, a portion of the conductor interconnection being opened, and that is electrically connected to ground potential. With this composition, the shield can be functioned as a return path of a high frequency signal propagating through the inductor. As a result, an electromagnetic interference between the inductor and other elements disposed around this inductor can be reduced.

Further, the above semiconductor device is arranged such that an interconnection width of the shield and a distance between the shield and the outer border of the interconnection of the inductor each are at least equal in size to a spacing of the spiral pattern of the inductor. With this composition, a capacitance between terminals of the inductor can be greatly reduced, and thereby the shield can be functioned as a return path of a high frequency signal propagating through the inductor. As a result, the electromagnetic interference between the inductor and other elements disposed therearound can be reduced.

The semiconductor device is arranged such that the device has a plurality of interconnection layers formed on the semiconductor substrate; the inductor is formed in anyone of these interconnection layers; and the shield is formed in the same interconnection layer as and/or a different interconnection layer from the interconnection layer in which the inductor is formed. With this composition, the capacitance between the terminals of the inductor can be greatly reduced, and thereby the shield can be functioned as the return path of the high frequency signal propagating through the inductor. As a result, the electromagnetic interference between the inductor and the other elements disposed therearound can be reduced.

According to the present invention, the semiconductor device includes: an inductor provided with a conductor interconnection formed in spiral form on a semiconductor substrate; and a shield that is provided with a continuous conductor interconnection provided along the inner periphery of the spiral pattern of the inductor, a portion of the conductor interconnection being opened, and that is electrically connected to ground potential. With this composition, the shield can be functioned as the return path of the high frequency signal propagating through the inductor. As a result, the electromagnetic interference between the inductor and other elements disposed therearound can be reduced.

Further, this semiconductor device is arranged such that the interconnection width of the shield is at most equal to the interconnection width of the inductor. With this composition, the capacitance between the terminals of the inductor can be remarkably reduced, and thereby the shield can be functioned as the return path of the high frequency signal propagating through the inductor. As a result, the electromagnetic interference between the inductor and other elements disposed therearound can be reduced.

### BRIEF DESCRIPTION OF THE DRAWINGS

FIG. 1 is a perspective plan view of a semiconductor device in accordance with Example 1 of the present invention, as seen through a passivation film and an interlayer film from above
FIG. 2 is a top view showing a pattern of an inductor of the semiconductor device.
FIG. 3 is a sectional view of the semiconductor device shown in FIG. 1, taken along the line A-A.
FIG. 4 is a top view showing a positional relation between the inductor and the shield.
FIG. 5A is a top view showing a configuration of a shield 6a in the semiconductor device in accordance with Example 1; FIG. 5B is a top view showing a configuration of a shield 6b; and FIG. 5C is a top view showing configurations of a shield 6c and a shield 6d.
FIG. 6 is a sectional view of the semiconductor device shown in FIG. 3, taken along the line B-B.
FIG. 7 is a view showing an equivalent circuit model of an inductor formed on a silicon substrate.
FIG. 8 is a sectional view showing an action of a magnetic field generated around the interconnection of an inductor.
FIG. 9 is a perspective plan view of a composition where the shield is formed just in the same aluminum interconnection layer as that in which the inductor is formed, as seen through a passivation film and an interlayer film from above.
FIG. 10 is a sectional view of the semiconductor device shown in FIG. 9, taken along the line C-C.
FIG. 11 is a view showing a notch portion provided in the shield interconnection.
FIG. 12 is a sectional view of the semiconductor device in which a patterned ground shield is provided in the composition in accordance with Example 1, taken similarly as in FIG. 3.
FIG. 13 is a view showing a patterned ground shield.
FIG. 14 is a perspective plan view of a semiconductor device in accordance with Example 2 of the present invention, as seen through a passivation film and an interlayer film from above.
FIG. 15 is a sectional view of the semiconductor device shown in FIG. 14, taken along the line D-D.
FIG. 16 is a sectional view of a semiconductor device in which a patterned ground shield is provided in a first aluminum interconnection layer in Comparative Example 3, taken at the same position as the line D-D in FIG. 14.
FIG. 17 is a perspective plan view of a semiconductor device in accordance with Example 3 of the present invention, as seen through passivation film and an interlayer film from above.
FIG. 18 is a perspective plan view of a semiconductor device in accordance with Example 4 of the present invention, as seen through a passivation film and an interlayer film from above.
FIG. 19 is a perspective plan view of a semiconductor device in accordance with an Embodiment of the present invention, as seen through a passivation film and an interlayer film from above.

### BEST MODE OF CARRYING OUT THE INVENTION

Hereinafter, the best mode for carrying out the present invention will be described with reference to the figures in order to make description in further detail of the present invention.

### Example 1

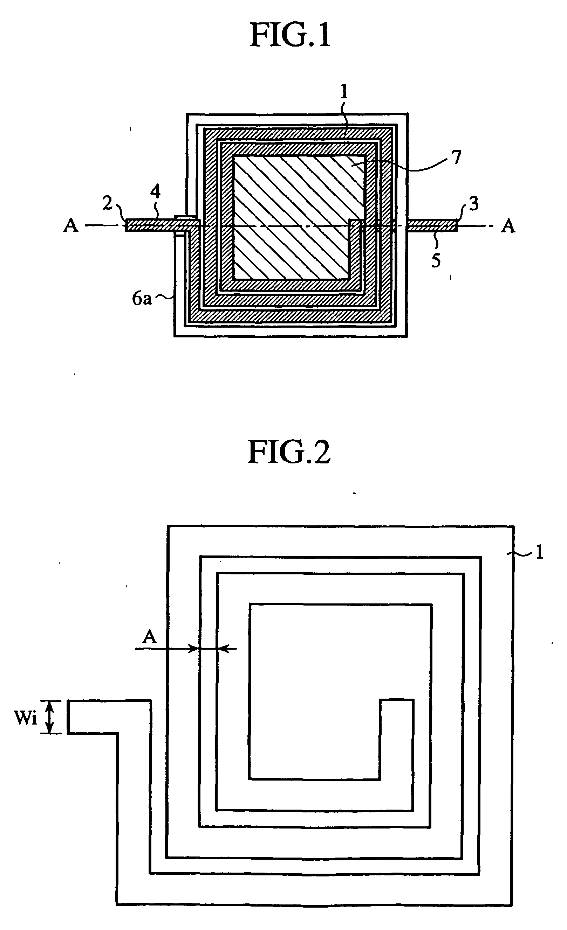

FIG. 1 is a perspective plan view of a semiconductor device in accordance with Example 1 of the present invention, as seen through a passivation film and an interlayer film from above, and FIG. 2 is a top view showing the pattern of the inductor of the semiconductor device. In the semiconductor device in accordance with this embodiment, as shown in FIG. 1, a shield 6a is provided such that the shield encloses an inductor 1 formed by laying out a interconnection in a spiral form. The dimensions of the inductor 1 are, as shown in FIG. 2, such that, for example, the interconnection width Wi is 10 µm, the interconnection spacing A of the spiral pattern is 2 µm, and the number of interconnection turns of the inductor is 2.5. The high frequency signal input from an input terminal 2 is output from an output terminal 3 through a lead wire 4, the inductor 1, and a lead-out wire 5. Moreover, a trench isolation part 7 is composed of silicon oxide and so on, and electrically separates a silicon substrate 10 and an interlayer film 11.

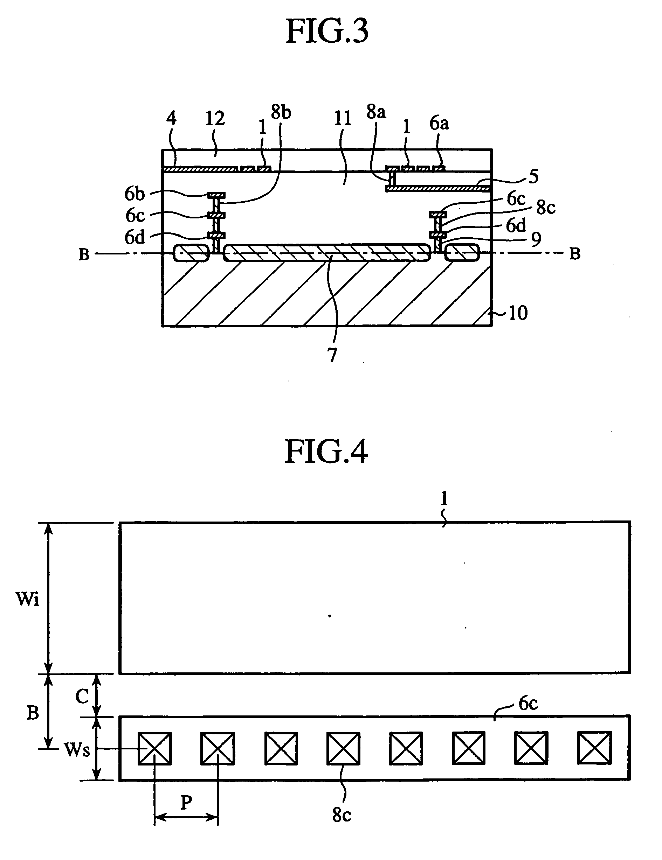

FIG. 3 is a sectional view of the semiconductor device shown in FIG. 1, taken along the line A-A. FIG. 4 is a top view showing a positional relation between the inductor and the shield. As shown in FIG. 3, the semiconductor device in accordance with this example has four-level interconnection layers formed of aluminum (hereinafter referred to as aluminum interconnection layers) layered on the silicon substrate 10 through insulating layers by means of a CMOS process. Herein, the inductor 1 and the lead wire 4 are formed in the fourth aluminum interconnection layer, which is the top layer, coated with passivation film. Further, the lead-out wire 5 is formed in the third aluminum interconnection layer, and is electrically connected with the inductor 1 through a via hole 8a.

In layers located under the shield 6a formed of the fourth aluminum interconnection layer to enclose the inductor 1, shields 6b, 6c, and 6d are provided. These shields 6b, 6c, and 6d are formed, as shown in FIG. 3, in the third, the second, and the first aluminum interconnection layers, respectively. Moreover, the shield 6b and the shield 6c are electrically connected through a via hole 8b, and the shield 6c and the shield 6d are electrically connected through a via hole 8c. Additionally, the shield 6d is electrically connected to the silicon substrate 10 through a contact hole 9.

The dimensions of these shields are, as shown in FIG. 4, such that the interconnection width Ws of each of these shields is 2 µm while the interconnection width Wi of the inductor 1 is 10 µm. Herein, these shields are formed such that the interconnection width Ws of each of the shields is at least equal to the size of the spacing A of the spiral pattern of the inductor 1. Moreover, it is arranged that the distance C between the outer border of the inductor 1 and each of the outer borders of the shields 6a-6d be 4 µm, the size being larger than or equal to that of the spacing A (2 µm) of the inductor 1. Further, it is arranged that the via hole 8b (or the via hole 8c) electrically connecting the shield 6b and the shield 6c (or the shield 6c and the shield 6d) be placed at the position where the distance B from the center of the via hole to the outer border of the inductor 1 is 5 µm, and that the pitch P between the adjoining via holes be 2 µm.

It is preferable that this pitch P be larger than or equal to the size of the spacing A of the inductor 1, and be smaller than or equal toone-fourthof thewavelengthof the high frequency signal, in order to prevent the loss of the high frequency signal resonating at the spacing between the via holes. Additionally, in this example, the via holes 8b, 8c are disposed such that each of the centers thereof is located on the centerline of the interconnection of the shield.

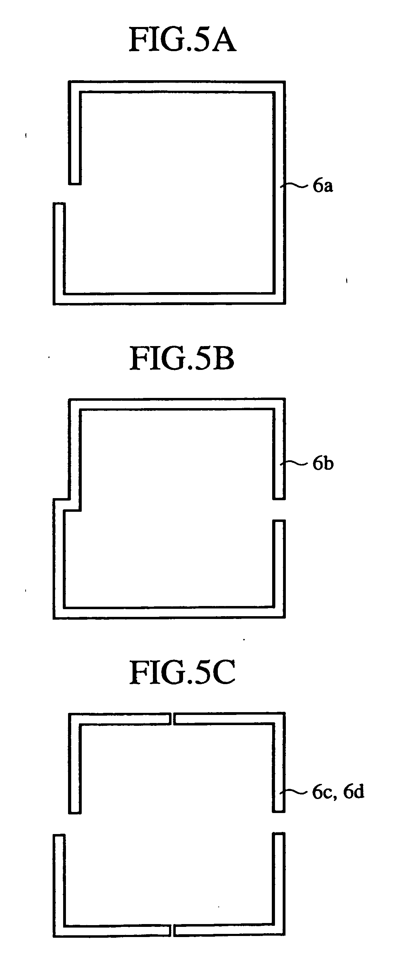

FIG. 5A is a top view showing a configuration of the shield 6a in the semiconductor device in accordance with Example 1, FIG. 5B is a top view showing a configuration of the shield 6b, and FIG. 5C is a top view showing configurations of the shield 6c and the shield 6d. As shown in FIG. 5A, the shield 6a has a ring shape opened at the position where the lead wire 4 is disposed, in order to dispose the wire. Similarly, the shield 6b has a ring shape opened at the position where the lead-out wire 5 is disposed, in order to dispose the wire (see FIG. 5B).

Moreover, the shields 6c, 6d are each composed of four portions that are separated at the position where the ring of the shield 6a is opened, at the position where the ring of the shield 6b is opened, and at other two positions (see FIG. 5C). Additionally, at least oneof these shields 6a-6d is electrically connected to the high frequency ground. In such a way, all the shields 6a-6d in this example are placed at the same potential as that of the high frequency ground.

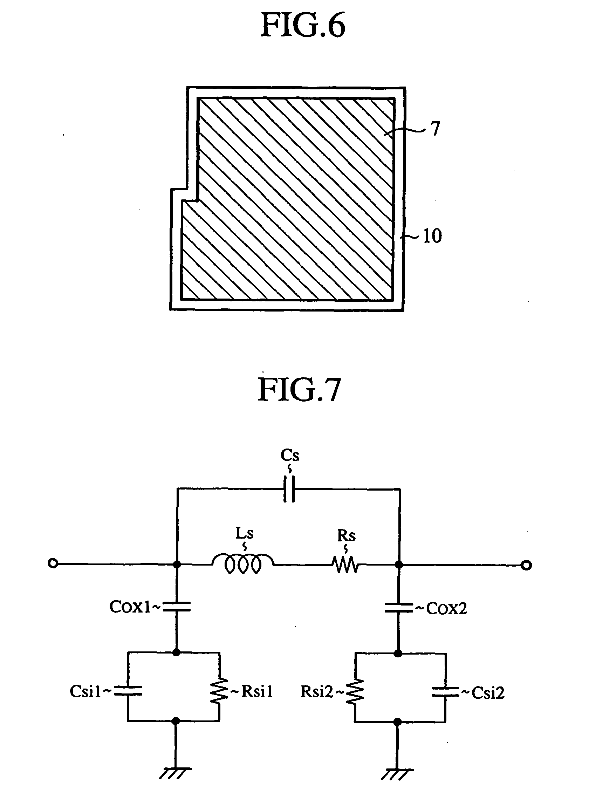

FIG. 6 is a sectional view of the semiconductor device shown in FIG. 3, taken along the line B-B, and the figure shows the trench isolation part 7 provided right under the inductor 1 and the surface of the silicon substrate located right under the shield 6d. The trench isolation part 7 is stacked by silicon oxide and so on over a trench formed on the silicon substrate 10, and then planarizing the place by means of CMP (Chemical Mechanical Polishing).

Moreover, when the trench isolation part 7 is formed in a comparatively wide area of the layer located under the inductor 1, it is necessary to provide a dummy pad, which is not shown in FIG. 6, over the silicon substrate 10. This dummy pad serves as the indicator showing the state of progress of the polishing and the completion of the polishing in the CMP process, and the pad is usually formed of silicon oxide.

The silicon substrate 10 only whose portion corresponding to the shape of the shield is shown in the figure is electrically connected with the shield 6d through the contact hole 9. When a P-type silicon substrate is used as the silicon substrate 10, the P-type concentration in the surface of the portion in which the silicon substrate 10 contacts the contact hole has been increased by means of ion implantation.

In such a way, the contact resistance of the contact hole 9 canbe reduced. Thus, the silicon substrate 10 is electrically connected to the high frequency ground through the shields 6a-6d, the via holes 8a-8c, and the contact hole 9. Therefore, the potential of the silicon substrate 10 becomes equal to that of the high frequency ground, and stabilized.

FIG. 7 is a view showing an equivalent circuit model of the inductor formed on the silicon substrate, and it is possible to represent the circuit of the semiconductor device according to the present invention by a similar model. In the example shown in the figure, a typical pi-type equivalent circuit of the inductor formed on the silicon substrate is represented. In the figure, Ls is the inductance of the inductor 1, Rs is the resistance of the inductor 1, and Cs is the inter-terminal capacitance between the input terminal 2 and the output terminal 3.

Moreover, Cox1 and Cox2 are the capacitances of oxide film of the input terminal 2 and the output terminal 3, respectively. The constituent elements, which are defined by the inductance Ls, the resistance Rs, the inter-terminal capacitance Cs, and the capacitances of oxide film Cox1, Cox2, are formed on the silicon substrate 10. Meanwhile, parasitic components formed inside the silicon substrate 10 include the capacitance of silicon substrate Csi1 of the input terminal 2, the capacitance of silicon substrate Csi2 of the output terminal 3, the resistance of silicon substrate Rsi1 of the input terminal 2, and the resistance of silicon substrate Rsi2 of the output terminal 3.

Herein, when a high frequency signal propagates through a signal interconnection, a return path corresponding to the signal interconnection is usually required. In the semiconductor device in accordance with this embodiment, the shield 6a placed around and close to the inductor 1 serves as the return path of the high frequency signal. In other words, the high frequency signal input from the input terminal 2 enters the inductor 1, and then the shields 6a-6d function as the return path, thereafter the signal being output from the output terminal 3.

Moreover, also in this return path, a slight flow of a high frequency current is generated. Thereby, the characteristics of the inductor 1 receive an influence caused by the resistances of the shields 6a-6d. To be more specific, a value of the resistive component Rs of the inductor 1 shown in the FIG. 7 is increased. Meanwhile, when a guard ring is formed of the silicon substrate as conventionally, instead of these shields 6a-6d, because the resistance thereof is extremely large as compared with the resistance of the aluminum interconnection, the value of the resistive component Rs of the inductor 1 also becomes large. When the value of the resistive component Rs of the inductor 1 is thus large, the inclination of the Q-value in the low frequency area is lowered, and the loss of the high frequency signal is increased.

Then, in the semiconductor device in accordance with this embodiment, the shields 6a-6c are formed of aluminum interconnection having high conductivity (low resistivity). Thereby, the value of the resistive component Rs of the inductor 1 can be prevented from increasing, and the inductor can be prevented from deteriorating its characteristics. In addition, the interconnection material is not limited to aluminum, and any metal having conductivity that is higher than that of the substrate (lower resistivity) can be used. For example, if the shield is formed with a conductor formed of copper, gold, and the like, the similar effect can be obtained.

Further, the shields 6a-6c are formed such that each of the interconnection widths Ws of the shields is larger than or equal to the size of the spacing A of the inductor 1 formed in the spiral pattern (at least the same size as that of the spacing A). If the shields 6a-6c meet these size requirements, the widths thereof do not need to be all the same.

The widest line width Ws of the shield is limited to the order of the size of the radius of the spiral pattern of the inductor 1. In addition, it is also preferred to form the shield 6a (or the shields 6b, 6c) such that the distance C between the shield 6a (or the shields 6b, 6c) and the outer border of the inductor 1 is larger than or equal to the size of the spacing A of the inductor 1 formed in the spiral pattern (at least the same size as the spacing A).

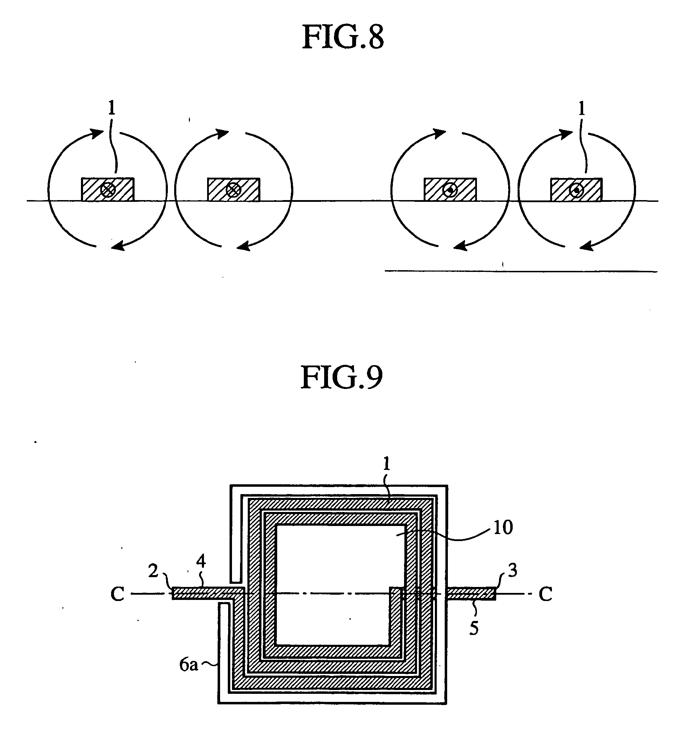

These size requirements will now be described as below. The magnetic fields generated by a spiral inductor like the inductor 1 act, as shown in FIG. 8, in the direction where the magnetic fields cancel or balance each other out in the portion in which the interconnections are closely placed (in the figure, between the interconnections the cross sections of which are marked with the same marks and in which an electric current flows in the same direction). On the other hand, the fields mutually act in the same direction in the portion in which the interconnections are loosely placed (in the figure, between the interconnections the cross sections of which are marked with different marks and in which an electric current flows in different directions from each other). As a result, a strong magnetic flux is generated in the center of the spiral of the inductor 1.

Herein, in the outermost interconnection in the spiral of the inductor 1, a magnetic flux turning around from outside to inside receives a canceling-out action produced by the magnetic flux generated in the interconnection adjacent thereto. On the other hand, a magnetic flux oriented from inside to outside does not receive the canceling-out action because there are no adjacent interconnections outside.

By contrast, a magnetic flux generated in the innermost interconnection in the spiral of the inductor 1 and turning around from inside to outside produces a cancel-out action with a magnetic flux generated in the interconnection adjacent thereto outside. Incidentally, the magnetic flux oriented from outside to inside does not receive the canceling-out action because there are no adjacent interconnections inside. For this reason, in the whole inductor 1, the magnetic flux turns around from the outside of the inductor 1 to the center thereof, and the magnetic flux is directed from the center to the outside.

In such an inductor 1, when the spacing A of the winding is enlarged without changing its diameter, the above-described relation between the actions of the magnetic fluxes collapses, and the flux density reduces. By contrast, even if the spacing A is reduced, the relation between the actions of the magnetic flux of the inductor 1 is not influenced. Therefore, reducing the size of the spacing A as much as possible enables downsizing of this semiconductor device as a result.

However, it is difficult to stably manufacture the products that are within the range of specifications if the dimension that is smaller than the range specified by the design rule in the manufacturing process is employed. Therefore, it is necessary that the spacing A be at least equal to or larger than the size specified by the design rule.

Thus, the spacing A of the inductor 1 is an important factor for determining the characteristic of the inductor 1 itself, and further, the spacing can be specified as the minimum unit of the size used at the time of determining the dimensions of the interconnections and the positional relation therebetween.

In addition, the high frequency current has a high current density over the surface of the conductor because of its skin effect. For this reason, the interconnection resistance is greatly influenced by the size in the width direction of the interconnection layer. For example, if it is assumed that the interconnection width Wi of the inductor 1 is 10 µm, and that the interconnection width Ws of the shield is 2 µm, it may be considered that the interconnection resistance of the shield is five times as large as that of the inductor 1.

Meanwhile, because the shield has a lowered function as the high frequency ground when its interconnection resistance is high, the resistive component Rs of the inductor 1 disadvantageously increases. For this reason, it is necessary to lower the interconnection resistance of the shield as much as possible; however, when the interconnection width Ws of the shield is increased in order to lower its interconnection resistance, the size reduction of the semiconductor device is limited.

For this purpose, further investigation and study into the minimum interconnection width Ws that can cause the shield to serve as the high frequency ground have shown that the shield can function as the high frequency ground if the shield has the interconnection width that is equal to the size of the spacing A of the inductor 1. As a result, in the semiconductor device in accordance with Embodiment 1, it is specified that the interconnection width Ws of the shield be larger than or equal to the size of the spacing A of the inductor 1 (at least the same size as the spacing A).

Moreover, it is also necessary to make specifications about the upper limit of the size of the interconnection width Ws of the shield. For example, when it is arranged that the interconnection width Ws of the shield be equal to the size of the radius of the spiral pattern of the inductor 1, the diameter of the inductor circuit portion including the shield is two times as large as the size of the spiral pattern of the main body of the inductor 1. In other words, the area of the inductor circuit portion is four times as large as the area occupied by the spiral pattern of the main body of the inductor 1. Then, in the semiconductor device in accordance with Embodiment 1, for the allowable range of the size of the shield, at most the level of the radius of the spiral pattern of the inductor 1 is specified as the upper limit of the interconnection width Ws of the shield.

Meanwhile, in order to cause the shield provided around the inductor 1 to serve as the return path of the high frequency signal, it is necessary to place the shield close to the outer border of the inductor 1. However, if the distance C between the shield and the outer border of the inductor 1 is too short, the high frequency signal entering the inductor 1 from the input terminal 2 passes through the path formed through the shield more easily than the signal is output through the inductor 1. Therefore, the inductance Ls and the Q-value are deteriorated, and the inter-terminal capacitance Cs is also increased.

Then, in consideration of the conditions for obtaining the desired characteristics of the semiconductor device, to be given thereto, and the design rule in the manufacturing process, the optimum size of the distance C between the shield and the outer border of the inductor 1 has been investigated and studied. As a result, it has been found that if the distance C is of approximately the same size as the spacing A of the inductor 1, the semiconductor device does not deteriorate its characteristics, and the high frequency current flowing through the inductor 1 more easily identifies the shield as the high frequency ground. Thereby, in the semiconductor device in accordance with Example 1, it is specified that the distance C between the shield and the outer border of the inductor 1 be larger than or equal to the size of the spacing A of the inductor 1 (at least the same size as the spacing A).

The selection of the above-mentioned range of the size thereof enables the shield serving as the return path to be placed most closely to the inductor 1 serving as the signal line without deteriorating the characteristics of the semiconductor device. Thereby, the high frequency signal input from the input terminal 2 comes to easily go to the shield from the input terminal 2 and the inductor 1; however, the high frequency signal also comes to easily return to the output terminal 3.

Accordingly, the inter-terminal capacitance Cs shown in the equivalent circuit shown in the FIG. 7 can be made so small that it may be ignored. In other words, the path through which the high frequency signal passes from the input terminal 2 to the output terminal 3 can be stably secured. Thereby, the electromagnetic interference between the elements disposed around the inductor 1 can be also reduced.

In the equivalent circuit shown in FIG. 7, the propagation path of the high frequency signal is determined on the basis of whether the inter-terminal capacitance Cs of the inductor 1 is larger or smaller than the parasitic capacitance existing between the inductor 1 and the element disposed therearound. At that time, when the potential of the element disposed around the inductor 1 is lower than that of the inductor 1, and further, the parasitic capacitance between the inductor 1 and the element is small, the high frequency signal easily flows through the path located on the side of the element. For this reason, the propagation path of the high frequency signal is not stabilized, and the path can cause the electromagnetic interference between the element disposed around the inductor 1 and the path.

By contrast, in the semiconductor device in accordance with Embodiment 1, it is arranged that the interconnection width Ws of the shield and the distance C between the shield and the outer border of the inductor 1 be larger than or equal to the size of the spacing A of the inductor 1 (at least the same size as the spacing A). As a result, the shield can serve as the high frequency ground, and the shield can reduce the electromagnetic interference between the elements disposed around the inductor and the inductor.

The effectiveness of the above-mentioned composition will now be described based on the comparison of the characteristic measurements with other various compositions. First of all, in order to explain the effectiveness of the shield in the semiconductor device in accordance with Example 1, the composition in which the shield 6a is provided only in the fourth aluminum interconnection layer in which the inductor 1 is provided is shown in FIG. 9.

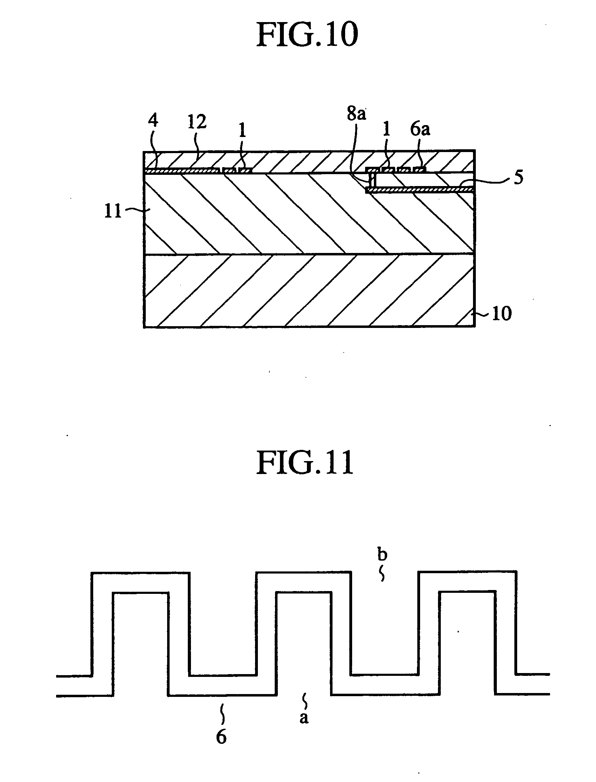

Additionally, FIG. 10 is a sectional view of the semiconductor device shown in FIG. 9, taken along the line C-C. The inductor 1 formed of the fourth aluminum interconnection layer is arranged such that the interconnection width Wi thereof is 10 µm, the spacing A of the inductor 1 is 2 µm, and the number of turns is 2.5. The lead-out wire 5 is formed of the third aluminum interconnection layer, and is connected with the inductor 1 through the via hole 8a. Therefore, the high frequency signal input from the input terminal 2 is output from the output terminal 3 through the leadwire 4, the inductor 1, and the lead-out wire 5.

The shield 6a formed in the fourth aluminum interconnection layer is arranged to have the interconnection pattern shown in FIG. 5A, and to meet the above-mentioned size requirements. The interconnection width Ws of the shield 6a is taken here to be 10 µm that is larger than or equal to the size of the spacing A of the inductor 1. Moreover, the distance C between the shield 6a and the outer border of the inductor 1 is also taken to be 2 µm falling within the size range that is larger than or equal to the size of the spacing A of the inductor 1.

Additionally, in the composition of FIG. 9, in order to show just the effect of the shield 6a, no trench isolation part 7 has been provided as shown in FIG. 10. Further, the shield 6a has no electric connection with the silicon substrates 10, and is connected to the high frequency ground not shown in the figure.

In order to show the effectiveness of this shield 6a, the measurement results on the characteristics obtained from the composition shown in FIG. 9 and other compositions are shown in Table 1. The other composition, which is obtained by removing the shield 6a from the composition shown in FIG. 9, is shown as Comparative Example 1. Moreover, the composition that has the constituent elements similar to that of the composition in FIG. 9 except that the distance C between the shield 6a and the outer border of the inductor 1 is 1 µm, falling outside the size range that is larger than or equal to the size of the spacing A of the inductor 1, is shown as Comparative Example 2.

It is possible to represent the semiconductor devices shown in FIG. 9 and shown as Comparison Examples 1, and 2 by the equivalent circuit model shown in FIG. 7. In Table 1, are shown the values calculated from the measurement results on the inductance Ls, the resistance Rs, and the inter-terminal capacitance Cs between the input terminal 2 and the output terminal 3, of the inductor 1 in these equivalent circuit models. In addition, in Table 1, are shown the measurements on the Q-value (Quality Factor), the self-resonant frequency, and the loss, of the inductor 1 in the high frequency signal of 5.2 GHz. Herein, the self-resonant frequency is the frequency in which the Q-value becomes zero.

**(Table 1)**

| | Ls(nH) | Rs (Ω) | Cs(fF) | Q-value in 5.2 GHz | Self-resonant frequency | Loss in 5.2 GHz |
|---|---|---|---|---|---|---|
| | | | | | (GHz) | (dB) |
| A | 1.2 | 5 | 5 | 4.1 | 13.0 | -1.2 |
| B | 1.2 | 5 | 27 | 5.5 | 13.1 | -1.4 |
| C | 1.0 | 5 | 44 | 3.5 | 12.8 | -1.2 |

As is apparent from Table 1, in the composition shown in FIG. 9 (shown with A in Table 1), the inductance Ls and the resistance Rs of the inductor 1 are almost equivalent of that of Comparative Examples 1 and 2 (shown with B and C, respectively, in Table 1) ; however, the inter-terminal capacitance Cs reduces on the order of 1/5. By contrast, in Comparative Example 2 in which the distance C does not meet the above-described size requirements, the inductance Ls and the Q-value deteriorate as compared with that of the compositions shown in FIG. 9 and Comparative Example 1, and further, the inter-terminal capacitance Cs increases on the order of nine times as compared with that of the composition shown in FIG. 9.

This arises from that because the distance C is too much reduced, the high frequency signal that must enter the inductor 1 from the input terminal 4 passes through the path passing through the shieldmore easily than output through the inductor 1. Thus, the distance C is found to be an important factor determining the characteristics of the semiconductor device.

According to the present invention, the distance C is specified within the above-described size range determined by considering the comparative results of the measured values shown in Table 1, thereby greatly reducing the inter-terminal capacitance Cs. Thereby, the electromagnetic interference between elements located around the inductor 1 can be reduced, which enables the great improvement of the characteristics of the semiconductor device. Further, this effect can be additionally increased by providing the shields in the layers located under the shield 6a as in the composition shown in FIG. 3.

In addition, in the semiconductor device in accordance with this embodiment, the shield 6a provided around the inductor 1 is formed in the form that encloses the inductor 1 by using its continuous body and is opened in one portion thereof. The purpose of thus opening a part of the shield is to prevent the path through which the induced current flows from being formed in the shield by the electromagnetic induction from the inductor 1.

In other words, this prevents the reduction of the inductance of the inductor 1, which is caused by the flow of the induced current through the shield and the occurrence of the mutual balancing out of the magnetic fields between the shield and the inductor 1. Moreover, as shown in FIG. 11, when notch portions a, b are formed in the shield interconnection, the path of the induced current generated by the electromagnetic induction from the inductor 1 can be more effectively intercepted.

Herein, forming the shield interconnection in the form where the interconnection is divided into two or more portions as in the shields 6c, 6d shown in FIG. 5C can also effectively prevent the induced current. However, in the discontinuous shields like the shields 6c, 6d shown in FIG. 5C, it is necessary to provide a path connected to the high frequency ground for each of the divided portions. When such a path is provided in the same aluminum interconnection layer, the area where the elements are disposed can be limited because of a complicated interconnection pattern and an enlarged area where the interconnection is disposed.

For this reason, in the semiconductor device according to the present invention, when a shield divided into a plurality of portions like the shields 6c, 6d shown in FIG. 5C is provided, in the layer located over or under the aluminum interconnection layer in which the shields 6c, 6d are formed, the shields 6a, 6b each having a continuous composition, shown in FIG. 5A and FIG. 5B are disposed. Then, the divided portions of each of the shields 6c, 6d are electrically connected with the shields 6a, 6b, extending between the aluminum interconnection layers through a via hole or the like provided therebetween.

Because the shields 6a, 6b can be connected to the high frequency ground even from any circumferential direction thereof, if only any of the shields 6a, 6b is connected to the high frequency ground, it is not necessary to connect each of the dividedportions of the shields 6c, 6d to the high frequency ground. Thereby, the interconnection pattern is not complicated, and the area where elements can be disposed is not used in an undesirable manner.

Further, in the semiconductor device in accordance with Embodiment 1, the via holes electrically connecting the shields formed in the aluminum interconnection layers are disposed at a 2-µm pitch. It is preferable that the pitch P at which the via holes are placed be larger than or equal to the spacing A of the inductor 1, and be smaller than or equal to one-fourth of the wavelength of the high frequency signal, in order to prevent the loss of the high frequency signal resonating at the spacing between the via holes.

As mentioned above, in accordance with Embodiment 1, the shields 6a, 6b each having a continuous composition in which one portion thereof is opened, and connected to the high frequency ground are arranged to enclose the spiral inductor 1. Consequently, the return path of the high frequency signal can be stabilized, and the electromagnetic interference between the inductor 1 and other elements disposed around the inductor can be reduced. As a result, it is possible to prevent the inductor 1 from changing its performance because of the electromagnetic influence from other elements disposed around the inductor 1. Moreover, one portion of each of the shields 6, 6b is opened, which can prevent the path of the induced current from being formed in the shield by the electromagnetic induction from the inductor 1.

In addition, in accordance with Example 1, it is arranged that the interconnection width Ws of the shield and the distance C between the shield and the outer border of the inductor 1 be larger than or equal to the spacing A of the spiral pattern of the inductor 1 (at least the same size as the spacing A). For this reason, the shield can be stabilized as the return path of the high frequency signal without deteriorating the characteristics of this semiconductor device. Thereby, the inter-terminal capacitance Cs, which is the parasitic component generated in the inductor 1, can be reduced. Thereby, the path through which the high frequency signal passes from the input terminal 2 to the output terminal 3 can be stably secured, and the electromagnetic interference between the elements disposed around the inductor 1 can be reduced.

Further, in Example 1, the case in which the silicon substrate 10 and the shield 6d are connected through the contact hole 9 is shown; however, if the interconnection area of the shield 6d is large, it is also possible to couple the silicon substrate 10 and the shield 6d by use the capacitance component formed therebetween as the high frequency. Accordingly, the silicon substrate and the shield do not need to be physically connected. When the silicon substrate is especially a substrate that cannot be directly connected with the shield, like the SOI (Silicon on insulator) substrate, the silicon substrate is coupled with the shield by use of the capacitance component formed therebetween in terms of high frequencies.

Moreover, when the spiral inductor like the inductor 1 is formed by means of a CMP process, a dummy pad has been conventionally formed such that the pad is adjacent to the periphery of the inductor 1. However, because this dummy pad incurs the increase of stray capacitance, the pad becomes a factor changing the characteristics of the inductor 1 when the pad is disposed adjacent to the inductor.

By contrast, in the semiconductor device according to the present invention, because the shield is disposed adjacent to the periphery of the inductor 1, the shield also acts as the dummy pad, thereby eliminating the necessity to place the dummy pad adjacent to the periphery of the inductor 1. As a result, the influence of the dummy pad formed by means of the CMP process can be reduced.

Additionally, on condition that the dummy pad and the shield can be formed such that the size of the pad is approximately equal to the interconnection width Ws of the shield, the dummy pad that is originally to be disposed, itself can be omitted. The same goes for the dummy pad disposed when the interconnection is formed by means of etching, too.

In the above-stated Example 1, the case in which the high frequency signal is propagated is explained by way of example; however, the invention is not limited to this. It is needless to say that, for example, if the invention is applied to a high-speed digital signal, the similar effect canbe expected. In addition, the present invention can be effectively applied to the inductor formed by using a process other than the CMOS process, and further, to the inductor formed on a substrates other than the silicon substrate.

When an electroconductive substrate like the silicon substrate is used, the combination of the shield and the patterned ground shield obtained in accordance with the above-mentioned Embodiment 1 can reduce the electromagnetic interference between the inductor 1 and other elements disposed around the inductor and the loss caused by the electroconductive substrate.

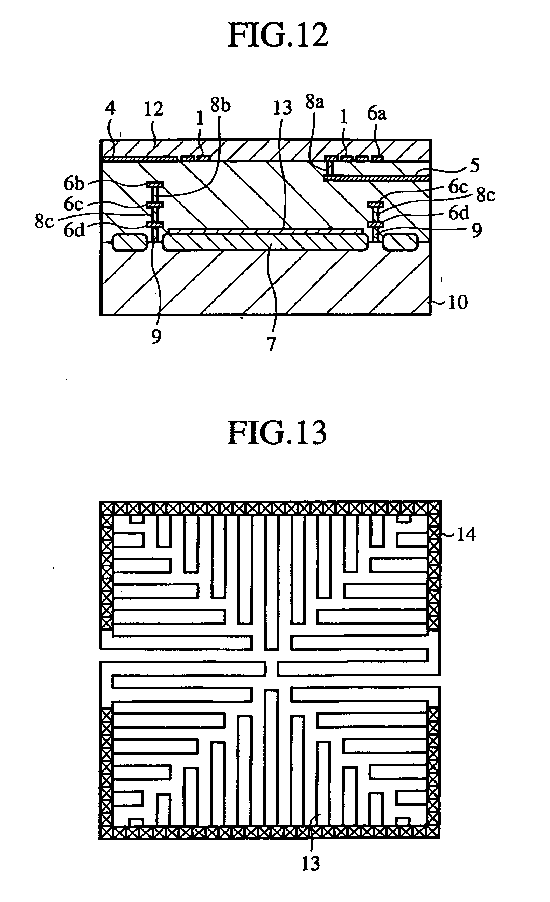

FIG. 12 is a sectional view of the semiconductor device in which a patterned ground shield is provided in the composition in accordance with Example 1, taken similarly as in FIG. 3. The patterned ground shield 13 is composed of a plurality of strip-shaped interconnection portions, and is formed on the top surface of the trench isolation part 7. Moreover, around the patterned ground shield, contact holes 14 for being electrically connected to the ground are disposed as shown in the top view of FIG. 13.

Such a composition can reduce the electromagnetic coupling between the inductor 1 and other elements disposed around the inductor by use of the shield similarly as in the above-mentioned Example 1. Furthermore, the composition can suppress the generation, within the silicon substrate 10, of the induced current that acts such that the current balances out the magnetic field generated by the high frequency current propagating through the inductor 1.

Briefly, the electromagnetic influence exerted on the inductor 1 through the inside of the silicon substrate 10 and the electromagnetic influence exerted in a direction perpendicularly of the face of the silicon substrate 10 can be reduced by the patterned ground shield 13. Moreover, the electromagnetic influence exerted from a direction parallel to the aluminum interconnection layers can be reduced by the shields 6a-6d.

### EMBODIMENT 2

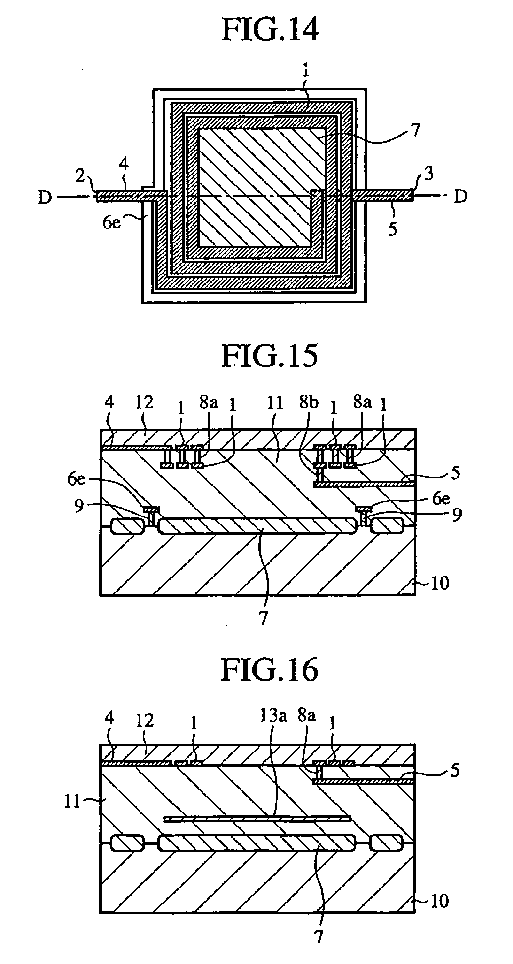

FIG.14 is a perspective plan view of a semiconductor device in accordance with Example 2 of the present invention, as seen through a passivation film and an interlayer film from above. FIG. 15 is a sectional view of the semiconductor device shown in FIG. 14, taken along the line D-D. As shown in FIG. 14, in the semiconductor device in accordance with this example, a shield 6e is provided such that the shield encloses an inductor 1 formed by laying out a interconnection in spiral form. Herein, the dimensions of the inductor 1 are such that the interconnection width Wi thereof is 10 µm, the spacing A in the spiral pattern is 2 µm, and the number of turns therein is 2.5.

Further, as shown in FIG. 15, the semiconductor device in accordance with this embodiment has four-level aluminum interconnection layers layered on a silicon substrate 10 through insulating layers by means of a CMOS process. The inductor 1 is formed in each of the fourth aluminum interconnection layer and the third aluminum interconnection layer, and the inductors are electrically connected, extending across these aluminum interconnection layers, through a via hole 8b.

A lead wire 4 is formed together with the inductor 1 in the fourth aluminum interconnection layer, which is the top layer, coated with a passivation film 12. A lead-out wire 5 is formed in the second aluminum interconnection layer, and is electrically connected with the inductor 1 formed in the third aluminum interconnection layer through the via hole 8b. The high frequency signal input from an input terminal 2 is output from an output terminal 3 through the lead wire 4, the inductors 1 formed in both the aluminum interconnection layers, and the lead-out wire 5.

A shield 6e is formed of the first aluminum interconnection layer farthest away from the inductor 1, and has a shape similar to that of the shield 6b shown in FIG. 5B. It is arranged that the interconnection width Ws of the shield 6e be 2 µm equaling the spacing A of the spiral pattern of the inductor 1. As shown in FIG. 15, the shield 6e is electrically connected to the silicon substrate 10 through a contact hole 9. In addition, it is arranged that the contact hole 9 be disposed at the position where the distance B from the center of the hole to the outer border of the inductor 1 is 5 µm, and that the pitch P between the adjoining contact holes be 2 µm.

It is preferable that this pitch P be larger than or equal to the spacing A of the inductor 1, and be smaller than or equal to one-fourth of the wavelength of the high frequency signal, in order to prevent the loss caused by the high frequency signal resonating at the spacing between the via holes. Further, the contact hole 9 is disposed such that the center of the hole is located on the centerline of the interconnection of the shield 6e.

In this example, the inductor 1 is provided in each of the two fourth and third aluminum interconnection layers, and just in the first aluminum interconnection layer, which is the farthest away from the inductor 1 and is the lowest layer, the shield 6e is provided. In order to show the effectiveness of this shield 6e, the measurement results on the characteristics will now be compared as below. In Table 2, is shown the measurement results on the characteristics of the semiconductor device in accordance with this example (shown with D in Table 2) and the conventional semiconductor devices.

**(Table 2)**

| | Ls (nH) | Rs (Ω) | Cs (fF) | Q-value in 5.2 GHz | Self-resonant frequency | Loss in 5.2 GHz |
|---|---|---|---|---|---|---|
| | | | | | (GHz) | (dB) |
| D | 1.7 | 5 | - | 6.1 | 14.0 | -1.6 |
| E | 1.7 | 4 | 8 | 6.6 | 14.0 | -1.6 |
| F | 1.6 | 6 | - | 5.1 | 11.0 | -1.1 |

Herein, the semiconductor device of Comparative Example 3 has the structure of the semiconductor device in accordance with Example 2, from which the shield 6e is removed (shown with E in Table 2).

Moreover, the semiconductor device of Comparative Example 4 has, as shown in FIG. 16, the structure that is obtained by providing a patterned ground shield 13a in the first aluminum interconnection layer of the semiconductor device of Comparative Example 3 (shown with F in Table 2). Further, the patterned ground shield 13a uses, for example, the same pattern as that shown in FIG. 13.

In addition, it is possible to represent the semiconductor devices in accordance with Example 2, and of Comparison Examples 3 and 4 by the model similar to the equivalent circuit model shown in FIG. 7. In Table 2, are shown the values calculated from the measurement results on the inductance Ls, the resistance Rs, and the inter-terminal capacitance Cs between the input terminal 2 and the output terminal 3, of the inductor 1 in these equivalent circuit models. In addition, in Table 2, are shown the measurements on the Q-value (Quality Factor), the self-resonant frequency, and the loss, of the inductor 1 in the high frequency signal of 5.2 GHz. The self-resonant frequency is a frequency at which the Q-value becomes zero.

As is apparent from Table 2, the inductance Ls in Embodiment 2 is approximately similar to that of Comparative Example 3; however, the resistive component Rs of the inductor 1 is slightly higher. However, while the inter-terminal capacitance Cs in the composition of Comparative Example 3 is about 8 fF, the capacitance in Example 2 is much smaller than 8 fF, and the value is so small that it may be ignored (marked with a sign "-" in Table 2).

By contrast, in Comparative Example 4, the effect that the loss reduces by the patterned ground shield 13a is obtained; however, the resistance Rs increases as compared with that of other compositions. For this reason, the Q-value reduces. In addition, there also arises the problem that the range of application of the frequency of the inductor 1 narrows because the self-resonant frequency thereof also reduces as compared with that of other compositions.

The high frequency signal input to the inductor 1 is influenced by the resistance of the shield. In this example, the shield 6e is formed just in the aluminum interconnection layer farthest away from the inductor 1, thereby slightly increasing the resistive component Rs of the inductor 1 as shown in Table 2.

Therefore, theQ-valueslightlyreduces. However,because the inter-terminal capacitance Cs becomes, by the shield 6e, so small that it may be ignored, the self-resonant frequency neither deteriorates, and the range of application of the frequency of the inductor 1 nor changes.

Accordingly, there arise no practical problems. Moreover, the inductors 1 are formed in the two layers, thereby also enabling the usage of a large-current high frequency signal that cannot flow through one inductor 1 formed just in one layer..

Thus, even if the shield specified under the above-mentioned dimensional requirements is formed just in the aluminum interconnection layer farthest away from the inductor 1, the effect of the reduction of the inter-terminal capacitance Cs explained in Embodiment 1 can be obtained. As a result, the occurrence of the problem caused by the electromagnetic interference can be prevented as compared with the case of other compositions.

In accordance with Example 2, because the film thickness of the interconnection is substantially increased by providing the inductor 1 in each of the two layers, a large-current high frequency signal that cannot flow through only one inductor 1 formed in one layer can be also used. Moreover, the shield 6e having the interconnection width Ws and the distance C that each are taken to be larger than or equal to the spacing A of the spiral pattern of the inductor 1 (at least the same size as the spacing A) is provided. For this reason, the shield can be stabilized as the return path of the high frequency signal without deteriorating the characteristics of this semiconductor device.

As described in the above example, even if the shield is formed in the aluminum interconnection layer farthest away from the inductor 1, the shield is effective. Accordingly, the provision of the shield also in the aluminum interconnection layer closer to the inductor 1 can further enhance the effect. In particular, the formation of the shield in a portion or all of the first aluminum interconnection layer to the fourth aluminum interconnection layer can reduce the resistance of the shield connected to the high frequency ground, and can also reduce the resistance of the inductor 1.

### Example 3

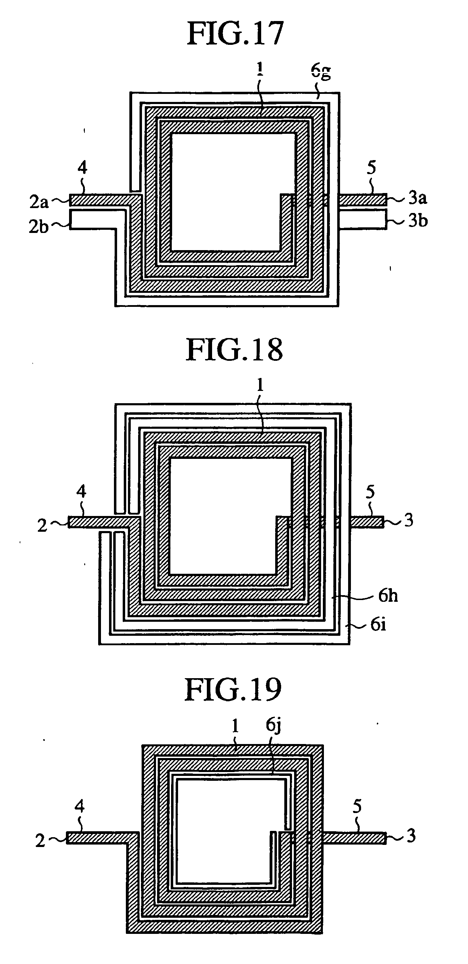

FIG. 17 is a perspective plan view of a semiconductor device in accordance with Example 3, as seen through a passivation film and an interlayer film from above. The semiconductor device in accordance with this example has, similarly as in Examples 1 and 2, four-level aluminum interconnection layers layered on a silicon substrate 10 through insulating layers by means of a CMOS process. An inductor 1 is formed in the fourth aluminum interconnection layer, which is the top layer, coated with a passivation film 12. A lead wire 4 and the inductor 1 are both formed in the fourth aluminum interconnection layer. A lead-out wire 5 is formed in the third aluminum interconnection layer, and is electrically connected with the inductor 1 formed in the fourth aluminum interconnection layer through a via hole. The high frequency signal input from an input terminal 2a is output from an output terminal 3a through the lead wire 4, the inductor 1, and the lead-out wire 5.

A shield 6g is formed in the fourth aluminum interconnection layer where the inductor 1 is formed such that the shield meets the dimensional requirements shown in the above-mentioned examples. Moreover, the shield 6g functions as the return path of the high frequency signal input through the input terminal 2a and output from the output terminal 3a. In order to cause the shield 6g to have this function, a interconnection on which an input terminal 2b is provided and which extends along the lead wire 4, is integrally formed together with the shield 6g, and further, a interconnection on which an output terminal 3b formed along the lead-out wire 5 in the third aluminum interconnection layer is provided, is electrically connected with the shield 6g through a via hole not shown in the figure.

Herein, a so-called coplanar strip line is formed each by the cross sectional shape made by the lead wire 4 that is a conductor interconnection on which the input terminal 2a is provided and the ground interconnection that is connected to the high frequency ground on which the input terminal 2b is provided; and by the cross-sectional shape made by the lead-out wire 5 that is a conductor interconnection on which the output terminal 3a is provided and the ground interconnection that is connected to the high frequency ground on which the output terminal 3b is provided. Accordingly, the characteristic impedances of these coplanar strip lines can be adjusted by changing the spacings between the lead wire 4 and the lead-out wire 5 that are both signal wires and the above-mentioned respective interconnections that are return lines.

In such a way, the input and output of the inductor 1 can be terminated by the characteristic impedance of the coplanar strip line. The impedance matching with the elements disposed before and after the inductor 1 can be easily performed.

In addition, the interconnection portion corresponding to the return path is connected to the high frequency ground, thereby enabling the connection between the shield 6g of the inductor 1 and the high frequency ground by use of the returns of the input terminal 2b and of the output terminal 3b. Thus, the area for routing the high frequency ground for the shield 6g of the inductor 1 can be reduced.

Moreover, in this example, the input terminal 2b and the output terminal 3b used the coplanar strip line; however, these terminals may use the combination of a coplanar line, a coplanar strip line, or a simple line.

### Example 4

FIG. 18 is a perspective plan view of a semiconductor device in accordance with Example 4, as seen through a passivation film and an interlayer film from above. The semiconductor device in accordance with this embodiment has, similarly as in Examples 1 and 2, four-level aluminum interconnection layers layered on a silicon substrate 10 through insulating layers by means of a CMOS process. An inductor 1 is formed in the fourth aluminum interconnection layer, which is the top layer, coated with a passivation film 12. A lead wire 4 is formed together with the inductor 1 in the fourth aluminum interconnection layer. A lead-out wire 5 is formed in the third aluminum interconnection layer, and is electrically connected with the inductor 1 formed in the fourth aluminum interconnection layer through a via hole. The high frequency signal input from an input terminal 2 is output from an output terminal 3 through the lead wire 4, the inductor 1, and the lead-out wire 5.

Shields 6h, 6i are formed in the fourth aluminum interconnection layer where the inductor 1 is formed such that the shields meet the dimensional requirements shown in the above-mentioned embodiments, and the shields are disposed to doubly enclose the inductor 1. Herein, the inter-terminal capacitance Cs of the inductor 1 is reduced by the shield 6h on the principle shown in Embodiment 1. In addition, the shields 6h, 6i can receive the unnecessary electromagnetic wave discharged from the inductor 1 by the high frequency signal input to the inductor 1.

Thus, in accordance with Example 4, the electromagnetic interference with other elements located in the vicinity of the inductor 1 can be reduced by the shields 6h, 6i multiply enclosing the inductor 1 more effectively than by the shield singularly enclosing the inductor.

### EMBODIMENT

FIG. 19 is a perspective plan view of a semiconductor device in accordance with an Embodiment of the present invention, as seen through a passivation film and an interlayer film from above. The semiconductor device in accordance with this embodiment has, similarly as in the above-described examples, four-level aluminum interconnection layers layered on a silicon substrate 10 through insulating layers by means of a CMOS process. An inductor 1 is formed in the fourth aluminum interconnection layer, which is the top layer, coated with a passivation film 12. A lead wire 4 is formed together with the inductor 1 in the fourth aluminum interconnection layer. A lead-out wire 5 is formed in the third aluminum interconnection layer, and is electrically connected with the inductor 1 formed in the fourth aluminum interconnection layer through a via hole. The high frequency signal input from an input terminal 2 is output from an output terminal 3 through the leadwire 4, the inductor 1, and the lead-out wire 5.

A shield 6j is disposed inside the spiral pattern of the inductor 1 as shown in FIG. 19. In this composition, in order to improve the performance of the inductor 1 without changing the diameter of the spiral pattern of the inductor, it is necessary to make as much room as possible in the central area of the spiral of the inductor 1. Moreover, in order for the resistive component of the inductor 1 not to increase, its interconnection width Wi must be of such size that the width does not influence the characteristics of the inductor.

For this reason, in this embodiment, the spacing A of the inductor 1 is defined as the most proximate spacing allowed by the design rule in the manufacturing process. In addition, in order to make room in the central area of the spiral of the inductor 1, the interconnection width Ws of the shield 6j must be as small as possible.

Then, it is specified that the interconnection width Ws of the shield 6j be at least larger than the size allowed by the design rule in the manufacturing process, with the interconnection width Wi of the inductor 1 as the upper limit. Briefly, the interconnectionwidthWs of the shield 6j is arranged to be smaller than or equal to the interconnection width Wi of the inductor 1 (at most the same size as the interconnection width Wi).

Such a composition can also reduce the inter-terminal capacitance Cs of the inductor 1, and can reduce the electromagnetic interference with elements located around the inductor 1.

Additionally, when the shield is disposed inside the spiral of the inductor 1 as in this embodiment, the distance between the input terminal 2 or the output terminal 3 and the shield is longer as compared with the composition in which the shield is disposed outside the inductor 1. Therefore, the degree to reduction of the inter-terminal capacitance Cs of the inductor 1 is lower.

However, disposing the shield 6j in the same layer as the one in which the inductor 1 is disposed and further arranging the interconnection width Ws of the shield 6j such that the interconnection width is smaller than or equal to the interconnection width Wi of the inductor 1 (at most the same size as the interconnection width Wi) enable the shield to have the roll similar to that of the dummy pad in the CMP process. For this reason, the stray capacitance caused by the dummy pad can be reduced.

Moreover, the application of the composition of the Embodiment to the compositions of the aforementioned Examples 1-4 can furthermore improve the effect of the reduction of the inter-terminal capacitance Cs of the inductor 1.

### INDUSTRIAL APPLICABILITY

As descried above, the semiconductor device according to the present invention can reduce the electromagnetic interference between an inductor and the elements located therearound by use of a continuous shield one portion of which is opened, located around the inductor, without adding the limitation to the size reduction of the device. The semiconductor device can be applied to a high-performance and compact high-frequency device.

## Claims

1. A semiconductor device comprising:
an inductor (1) provided with a conductor interconnection formed spirally on a semiconductor substrate (10); and
a shield (6j) that is provided with a conductor interconnection in a ring having a continuous configuration provided with opening a portion of the conductor interconnection, and that is electrically connected to ground potential,
**characterized in that**
the conductor interconnection of the shield (6j) is provided along the inner periphery of the spiral pattern of the inductor (1).

2. A semiconductor device according to Claim 1, wherein a interconnection width (Ws) of the shield (6j) is equal to or less than the size of a interconnection width (Wi) of the inductor (6j).

## Patentansprüche

1. Halbleitervorrichtung, die umfasst:
einen Induktor (1), der mit einer Leiterverbindung versehen ist, die auf einem Halbleitersubstrat (10) spiralförmig ausgebildet ist; und
eine Abschirmung (6j), die mit einer Leiterverbindung in einem Ring versehen ist, der eine ununterbrochene Konfiguration aufweist und mit einem Öffnungsabschnitt der Leiterverbindung versehen ist, und die mit Massepotential elektrisch verbunden ist,
**dadurch gekennzeichnet, dass**
die Leiterverbindung der Abschirmung (6j) längs des inneren Umfangs des spiralförmigen Musters des Induktors (1) vorgesehen ist.

2. Halbleitervorrichtung nach Anspruch 1, wobei eine Verbindungsbreite (Ws) der Abschirmung (6j) gleich oder kleiner als die Größe einer Verbindungsbreite (Wi) des Induktors (6j) ist.

## Revendications

1. Dispositif à semi-conducteur comprenant :
une bobine inductrice (1) dotée d'une interconnexion conductrice formée en spirale sur un substrat semi-conducteur (10) ; et
un blindage (6j) qui est doté d'une interconnexion conductrice dans un anneau ayant une configuration continue doté d'une partie d'ouverture de l'interconnexion conductrice et qui est connecté électriquement au potentiel de masse,
**caractérisé en ce que**
l'interconnexion conductrice du blindage (6j) est prévue le long de la périphérie interne du motif en spirale de la bobine inductrice (1).

2. Dispositif à semi-conducteur selon la revendication 1, dans lequel une largeur d'interconnexion (Ws) du blindage (6j) est inférieure ou égale à la dimension d'une largeur d'interconnexion (Wi) de la bobine inductrice (6j).
